# EUROPEAN PATENT APPLICATION

(11) **EP 4 679 667 A1**
(43) Date of publication of application: **14.01.2026**
(21) Application number: 25185408.9
(22) Date of filing: 26.06.2025
(51) Int. Cl.: H02J 7/00, G01R 31/385, H01M 10/42, H01M 10/48

(54) **SECONDARY BATTERY CHARGE AND DISCHARGE PIN AND PROBE FOR SECONDARY BATTERY CHARGE AND DISCHARGE TEST INCLUDING THE SAME**

(30) Priority: 27.06.2024 KR 20240084671
(71) Applicant: SAMSUNG SDI CO., LTD., Yongin-si, Gyeonggi-do 17084 (KR)
(72) Inventor: EO, Soo-Mi, 17084 Yongin-si, Gyeonggi-do (KR); LEE, Jeawoan, 17084 Yongin-si, Gyeonggi-do (KR); HWANG, Hyunjin, 17084 Yongin-si, Gyeonggi-do (KR); LEE, Byeongryeol, 17084 Yongin-si, Gyeonggi-do (KR)
(74) Representative: Gulde & Partner

(57) **Abstract**

The present disclosure provides a secondary battery charge and discharge pin (120, 220, 420, 600, 800, 1020, 1312) and a probe for a secondary battery charge and discharge test including the same. A secondary battery charge and discharge pin (120, 220, 420, 600, 800, 1020, 1312) according to the present disclosure includes a head (122, 222, 422, 1100, 1314) configured to come into contact with a terminal of a secondary battery (112, 312, 512, 712, 912, 1012), and an insulating member (130, 230, 430, 630, 830, 930, 1030, 1130, 1230, 1316) configured to cover at least a part of the head (122, 222, 422, 1100, 1314).

## Description

### BACKGROUND

### Field

The present disclosure relates to a secondary battery charge and discharge pin and a probe for a secondary battery charge and discharge test including the same.

### Description of the Related Art

Unlike primary batteries that are not designed to be (re)charged, secondary (or rechargeable) batteries are batteries that are designed to be discharged and recharged. Low-capacity secondary batteries are used in portable, small electronic devices, such as smart phones, feature phones, notebook computers, digital cameras, and camcorders, while large-capacity secondary batteries are widely used as power sources for driving motors in hybrid vehicles and electric vehicles and for storing power (e.g., home and/or utility scale power storage). A secondary battery generally includes an electrode assembly composed of a positive electrode and a negative electrode, a case accommodating the same, and electrode terminals connected to the electrode assembly.

Secondary batteries are used in various environments due to excellent electrical characteristics. However, there is a limit to an energy density that may be designed for existing small batteries. Because the amount of electrical energy that may be stored is restricted compared to a size and a weight of the battery, it is desirable to use large batteries with a higher energy density in applications of electric vehicles and the like.

For all completed secondary batteries, a procedure of measuring electrical characteristics including a charge and discharge test is performed in order to test performance or defectiveness of the secondary battery. In this procedure, defective products that do not fall within specifications are excluded.

In the example of cells (or secondary batteries) using a stainless steel case (SUS can), there is a risk that a flange remaining after welding and cutting processes may come into contact with a charge and discharge pin during the charge and discharge test to cause a short circuit. In particular, in order to test high currents, because a sectional size of the charge and discharge pin increases and a thickness of the cell becomes thinner, there is a high risk that the short circuit is caused.

The above information disclosed in this Background section is for enhancement of understanding of the background of the present disclosure, and therefore, it may contain information that does not constitute related (or prior) art.

### SUMMARY

Aspects of some embodiments of the present disclosure are directed to a secondary battery charge and discharge pin and a probe for a secondary battery charge and discharge test in order to solve the above technical problem.

These and other aspects and features of the present disclosure will be described in or will be apparent from the following description of embodiments of the present disclosure.

According to some embodiments of the present disclosure, there is provided a secondary battery charge and discharge pin including: a head configured to come into contact with a terminal of a secondary battery; and an insulating member configured to cover at least a part of the head.

In some embodiments, the insulating member may be formed on the head to be positioned near a flange formed in a case of the secondary battery in a state where the head comes into contact with the terminal of the secondary battery.

In some embodiments, the head may include a first head and a second head, the second head may be configured to come into direct contact with the terminal of the secondary battery, and a diameter of the first head may be larger than a diameter of the second head.

In some embodiments, a height of the second head may be greater than or equal to a difference between a height of a flange formed in a case of the secondary battery and a height of the terminal.

In some embodiments, the insulating member may be on at least a part of an outer peripheral surface of the second head and at least a part of an upper surface of the first head.

In some embodiments, the second head may have an inclined surface inclined at an angle with respect to an extending direction of the first head and the second head, and the insulating member may be on at least a part of the inclined surface of the second head.

In some embodiments, a side surface of the head may include a curved surface portion and a flat surface portion connected to the curved surface portion.

In some embodiments, the insulating member may be on at least a part of the flat surface portion.

In some embodiments, a plurality of projections may be formed on a contact surface of the head that is configured to come into direct contact with the terminal of the secondary battery.

According to some embodiments of the present disclosure, there is provided a probe for a secondary battery charge and discharge test including: an external plunger including a charge and discharge pin; and an internal plunger configured to move up and down inside the external plunger, wherein the internal plunger is electrically insulated from the external plunger, and wherein the charge and discharge pin includes a head configured to come into contact with a terminal of a secondary battery and an insulating member that covers at least a part of the head.

In some embodiments, the insulating member may be formed on the head to be positioned near a flange formed in a case of the secondary battery in a state where the head comes into contact with the terminal of the secondary battery.

In some embodiments, the head may include a first head and a second head, the second head may be configured to come into direct contact with the terminal of the secondary battery, and a diameter of the first head may be larger than a diameter of the second head.

In some embodiments, a height of the second head may be greater than or equal to a difference between a height of a flange formed in a case of the secondary battery and a height of the terminal.

In some embodiments, the insulating member may be on at least a part of an outer peripheral surface of the second head and at least a part of an upper surface of the first head.

In some embodiments, the second head may have an inclined surface inclined at an angle with respect to an extending direction of the first head and the second head, and the insulating member may be on at least a part of the inclined surface of the second head.

In some embodiments, a side surface of the head may include a curved surface portion and a flat surface portion connected to the curved surface portion.

In some embodiments, the insulating member may be on at least a part of the flat surface portion.

In some embodiments, a plurality of projections may be formed on a contact surface of the head that is configured to come into direct contact with the terminal of the secondary battery.

In some embodiments, the probe for a secondary battery charge and discharge test may further include: an insulating layer along an outer peripheral surface of the internal plunger.

In some embodiments, the probe for a secondary battery charge and discharge test further may include: an elastic body on an outer surface of the external plunger.

According to some embodiments of the present disclosure, it is possible to provide a probe for a charge and discharge test that can perform a charge and discharge test of a secondary battery by using high current by variously modifying a shape of a charge and discharge pin of a secondary battery while eliminating a risk of a short circuit.

However, aspects and features of the present disclosure are not limited to those described above, and other aspects and features not mentioned will be clearly understood by a person skilled in the art from the detailed description, described below.

All embodiments described in this specification may be advantageously combined with one another to the extent that their respective features are compatible. In particular, the expressions "according to an embodiment," "in an embodiment," "an embodiment of the invention provides" etc. mean that the respective features may or may not be part of specific embodiments of the present invention.

### BRIEF DESCRIPTION OF DRAWINGS

The following drawings attached to this specification illustrate embodiments of the present disclosure, and further describe aspects and features of the present disclosure together with the detailed description of the present disclosure. Thus, the present disclosure should not be construed as being limited to the drawings:
FIG. 1 is a perspective view schematically illustrating a secondary battery case and a secondary battery charge and discharge pin according to some embodiments of the present disclosure.
FIGS. 2 and 3 are diagrams illustrating a charge and discharge pin and a secondary battery case according to some embodiments of the present disclosure.
FIGS. 4 and 5 are diagrams illustrating a charge and discharge pin and a secondary battery case according to some embodiments of the present disclosure.
FIGS. 6 and 7 are diagrams illustrating a charge and discharge pin and a secondary battery case according to some embodiments of the present disclosure.
FIG. 8 is a diagram illustrating a charge and discharge pin according to some embodiments of the present disclosure.
FIG. 9 is a diagram illustrating a charge and discharge pin and a secondary battery case according to some embodiments of the present disclosure.
FIG. 10 is a diagram illustrating a charge and discharge pin and a secondary battery case according to some embodiments of the present disclosure.
FIGS. 11 and 12 are diagrams illustrating a section of a charge and discharge pin head according to some embodiments of the present disclosure.
FIG. 13 is a longitudinal cross section of a probe for a secondary battery charge and discharge test according to some embodiments of the present disclosure.

### DETAILED DESCRIPTION

Hereinafter, embodiments of the present disclosure will be described, in detail, with reference to the accompanying drawings. The terms or words used in this specification and claims should not be construed as being limited to the usual or dictionary meaning and should be interpreted as meaning and concept consistent with the technical idea of the present disclosure based on the principle that the inventor can be his/her own lexicographer to appropriately define the concept of the term to explain his/her invention in the best way.

The embodiments described in this specification and the configurations shown in the drawings are only some of the embodiments of the present disclosure and do not represent all of the technical ideas, aspects, and features of the present disclosure. Accordingly, it should be understood that there may be various equivalents and modifications that can replace or modify the embodiments described herein at the time of filing this application.

It will be understood that when a layer or element is referred to as being "between" two layers, it can be the only layer between the two layers, or one or more intervening layers may also be present. It will be understood that when an element or layer is referred to as being "on," "connected to," or "coupled to" another element or layer, it may be directly on, connected, or coupled to the other element or layer or one or more intervening elements or layers may also be present. When an element or layer is referred to as being "directly on," "directly connected to," or "directly coupled to" another element or layer, there are no intervening elements or layers present. For example, when a first element is described as being "coupled" or "connected" to a second element, the first element may be directly coupled or connected to the second element or the first element may be indirectly coupled or connected to the second element via one or more intervening elements.

In the figures, dimensions of the various elements, layers, etc. may be exaggerated for clarity of illustration. The same reference numerals designate the same elements. As used herein, the term "and/or" includes any and all combinations of one or more of the associated listed items. Further, the use of "may" when describing embodiments of the present disclosure relates to "one or more embodiments of the present disclosure." Expressions, such as "at least one of" and "any one of," when preceding a list of elements, modify the entire list of elements and do not modify the individual elements of the list. When phrases such as "at least one of A, B and C, "at least one of A, B or C," "at least one selected from a group of A, B and C," or "at least one selected from among A, B and C" are used to designate a list of elements A, B and C, the phrase may refer to any and all suitable combinations or a subset of A, B and C, such as A, B, C, A and B, A and C, B and C, or A and B and C. As used herein, the terms "use," "using," and "used" may be considered synonymous with the terms "utilize," "utilizing," and "utilized," respectively. As used herein, the terms "substantially," "about," and similar terms are used as terms of approximation and not as terms of degree, and are intended to account for the inherent variations in measured or calculated values that would be recognized by those of ordinary skill in the art.

It will be understood that, although the terms first, second, third, etc. may be used herein to describe various elements, components, regions, layers, and/or sections, these elements, components, regions, layers, and/or sections should not be limited by these terms. These terms are used to distinguish one element, component, region, layer, or section from another element, component, region, layer, or section. Thus, a first element, component, region, layer, or section discussed below could be termed a second element, component, region, layer, or section without departing from the teachings of example embodiments.

Spatially relative terms, such as "beneath," "below," "lower," "above," "upper," and the like, may be used herein for ease of description to describe one element or feature's relationship to another element(s) or feature(s) as illustrated in the figures. It will be understood that the spatially relative terms are intended to encompass different orientations of the device in use or operation in addition to the orientation depicted in the figures. For example, if the device in the figures is turned over, elements described as "below" or "beneath" other elements or features would then be oriented "above" or "over" the other elements or features. Thus, the term "below" may encompass both an orientation of above and below. The device may be otherwise oriented (rotated 90 degrees or at other orientations), and the spatially relative descriptors used herein should be interpreted accordingly.

The terminology used herein is for the purpose of describing embodiments of the present disclosure and is not intended to be limiting of the present disclosure. As used herein, the singular forms "a" and "an" are intended to include the plural forms as well, unless the context clearly indicates otherwise. It will be further understood that the terms "includes," "including," "comprises," and/or "comprising," when used in this specification, specify the presence of stated features, integers, steps, operations, elements, and/or components but do not preclude the presence or addition of one or more other features, integers, steps, operations, elements, components, and/or groups thereof.

Also, any numerical range disclosed and/or recited herein is intended to include all sub-ranges of the same numerical precision subsumed within the recited range. For example, a range of "1.0 to 10.0" is intended to include all subranges between (and including) the recited minimum value of 1.0 and the recited maximum value of 10.0, that is, having a minimum value equal to or greater than 1.0 and a maximum value equal to or less than 10.0, such as, for example, 2.4 to 7.6. Any maximum numerical limitation recited herein is intended to include all lower numerical limitations subsumed therein, and any minimum numerical limitation recited in this specification is intended to include all higher numerical limitations subsumed therein. Accordingly, Applicant reserves the right to amend this specification, including the claims, to expressly recite any sub-range subsumed within the ranges expressly recited herein. All such ranges are intended to be inherently described in this specification such that amending to expressly recite any such subranges would comply with the requirements of 35 U.S.C. § 112(a) and 35 U.S.C. § 132(a).

References to two compared elements, features, etc. as being "the same" may mean that they are "substantially the same". Thus, the phrase "substantially the same" may include a case having a deviation that is considered low in the art, for example, a deviation of 5% or less. In addition, when a certain parameter is referred to as being uniform in a given region, it may mean that it is uniform in terms of an average.

Throughout the specification, unless otherwise stated, each element may be singular or plural.

Arranging an arbitrary element "above (or below)" or "on (under)" another element may mean that the arbitrary element may be disposed in contact with the upper (or lower) surface of the element, and another element may also be interposed between the element and the arbitrary element disposed on (or under) the element.

In addition, it will be understood that when a component is referred to as being "linked," "coupled," or "connected" to another component, the elements may be directly "coupled," "linked" or "connected" to each other, or another component may be "interposed" between the components".

Throughout the specification, when "A and/or B" is stated, it means A, B or A and B, unless otherwise stated. That is, "and/or" includes any or all combinations of a plurality of items enumerated. When "C to D" is stated, it means C or more and D or less, unless otherwise specified.

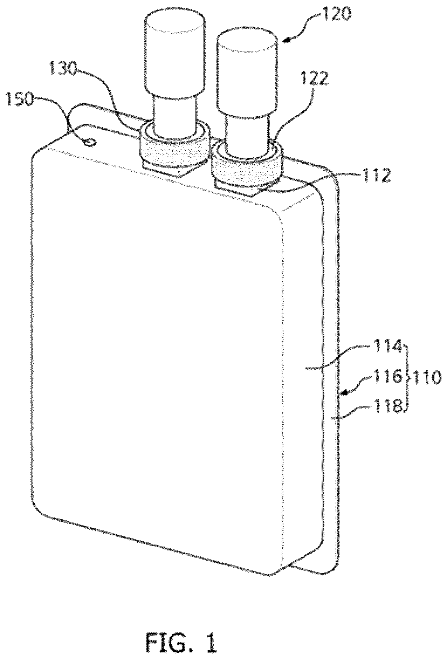

FIG. 1 is a perspective view schematically illustrating a secondary battery case and a secondary battery charge and discharge pin according to some embodiments of the present disclosure.

Referring to FIG. 1, each of secondary battery charge and discharge pins 120 according to some embodiments of the present disclosure may include a head 122 that comes into contact with a terminal 112 of a secondary battery and an insulating member 130 that covers at least a part of the head 122.

In some embodiments, the secondary battery may include a secondary battery case 110 and an electrode assembly disposed inside the secondary battery case 110. For example, the secondary battery may include the electrode assembly (e.g., at least one or more electrode assemblies wound or stacked with a separator which is an insulator interposed between a positive electrode and a negative electrode) and the case 110 in which the electrode assembly is embedded.

The positive electrode and the negative electrode may include a coated portion, which is a region where an active material is coated to a current collector made of a thin metal foil, and a non-coated portion, which is a region where an active material is not coated. After the separator which is the insulator is interposed between the positive electrode and the negative electrode, the positive electrode and the negative electrode may be wound. However, the present disclosure is not limited thereto, and the electrode assembly may be formed in a structure in which a plurality of sheets of positive electrodes and negative electrodes are alternately stacked with the separator interposed therebetween. In some other embodiments, the electrode assembly may be any structure including an electrode.

In some embodiments, the secondary battery may include a lithium battery cell, a sodium battery cell, or the like. However, the scope of the present disclosure is not limited thereto, and the battery cell or the secondary battery may include all batteries that may repeatedly provide electricity through charge and discharge. For example, when the battery cell is the lithium battery cell, the battery cell may be used in mobile phones, power tools, electric bicycle tools, and the like. In some other examples, the battery cell may be used in hybrid vehicles such as electric vehicles (EV) and plug-in hybrid electric vehicles (PHEV).

In some embodiments, the secondary battery case 110 may be manufactured in a shape corresponding to the electrode assembly in order to accommodate the electrode assembly. For example, the secondary battery case 110 may form an overall appearance of the secondary battery, and may be made of metal such as stainless steel (e.g., SUS), aluminum, aluminum alloy, nickel-plated steel, or the like. The secondary battery case 110 may provide a space for accommodating the electrode assembly, and an insulating coating material may be coated on an outer peripheral surface or an inner peripheral surface of a space with a certain thickness.

As illustrated in FIG. 1, the secondary battery case 110 may include the terminals 112 electrically connected to the electrodes of the electrode assembly, a body case 114 having a cup shape for accommodating the electrode assembly, a cover case 116 coming into contact with the body case 114, and a flange 118 formed in a process of welding the body case 114 and the cover case 116.

The terminal 112 may include a positive terminal electrically connected to the positive electrode and a negative terminal electrically connected to the negative electrode. The terminal 112 may be bonded integrally with the case 110. In some embodiments, the terminal 112 may be installed on at least one surface of the case 110 as illustrated in FIG. 1. A position of the terminal 112 is not limited to the position illustrated in FIG. 1 and may be changed as needed. For example, the positive terminal and the negative terminal may be installed on both sides facing each other. In such examples, the charge and discharge pin 120 coming into contact with the terminal 112 may be disposed to face each other.

In some embodiments, a depth of the body case 114 may be formed to be greater than or equal to 3 mm and less than or equal to 7 mm.

In the secondary battery case 110, the body case 114 and the cover case 116 may be joined or sealed with each other. For example, the case 110 may be formed by metal joining (e.g., via welding, brazing, soldering, or the like) of the body case 114 and the cover case 116. With such a configuration, the flange 118 may be formed by joining in the secondary battery case 110. In some embodiments, the secondary battery case 110 may be manufactured by using a hard material to be metal-joined.

The flange 118 may be formed to extend from the body case 114 or the cover case 116. In some embodiments, an extending direction of the flange 118 may be parallel to a longitudinal direction of the charge and discharge pin 120. In some embodiments, the flange 118 may extend to have a length of about 0.5 mm to about 3 mm from an end of the body case 114 or an end of the cover case 116.

In some embodiments, the case 110 may include an electrolyte inlet 150. For example, the electrolyte inlet 150 may be a through-hole formed in at least one surface of the case 110. The electrolyte inlet 150 may be formed to inject an electrolyte into the case 110 after the body case 114 and the cover case 116 are joined and sealed. The electrolyte inlet 150 may be sealed with a sealing member after the electrolyte is injected.

An appearance of the secondary battery case 110 illustrated in FIG. 1 for the description of the invention is merely an example, and the scope of the present disclosure is not limited thereto.

According to some embodiments, the insulating member 130 may be disposed on at least a part of the head 122 of the secondary battery charge and discharge pin 120. In some embodiments, the insulating member 130 may be formed on the head 122 to be disposed near the flange 118 formed in the secondary battery case 110 in a state where the head 122 comes into contact with the terminal 112 of the secondary battery case 110. For example, the insulating member 130 may be interposed between the head 122 and the flange 118 in order to electrically insulate the secondary battery charge and discharge pin 120 and the secondary battery case 110 during the charge and discharge of the secondary battery. The shape and disposition of the insulating member 130 will be described later with reference to the following drawings.

The insulating member 130 may be made of a material with high insulating properties in order to electrically insulate the case 110 and the secondary battery charge and discharge pin 120. For example, the insulating member 130 may be made of a polymer including ethylene propylene rubber (EPDM), polypropylene (PP), polyimide (PI), polyethylene terephthalate (PET), polycarbonate (PC), or a combination thereof.

In some other examples, the insulating member 130 may be made of a ceramic material including epoxy resin, alumina (Al₂O₃), zirconia (ZrO₂), aramid fiber, Nomex, or a combination thereof. However, the material of the insulating member 130 is not limited to the materials listed above and may include various materials with excellent plasticity and insulating properties, depending on the choice of those skilled in the art.

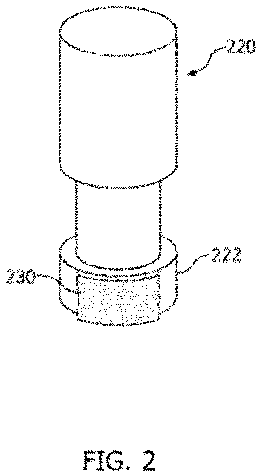

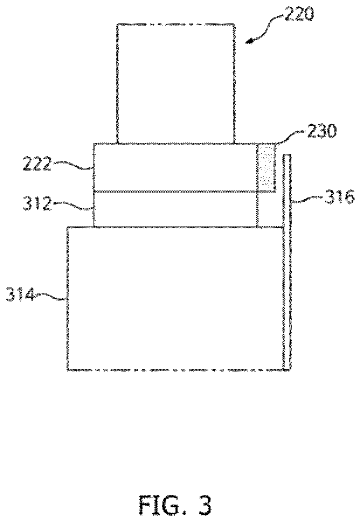

FIGS. 2 and 3 are diagrams illustrating a charge and discharge pin and a secondary battery case according to some embodiments of the present disclosure.

Referring to FIG. 2, a secondary battery charge and discharge pin 220 may include a head 222 that comes into contact with the terminal of the secondary battery and an insulating member 230 that covers at least a part of the head 222.

Referring to FIG. 3, the insulating member 230 may be formed on the head 222 to be disposed near a flange 316 formed in the secondary battery case in a state where the head 222 comes into contact with a terminal 312 of the secondary battery. For example, the insulating member 230 may be interposed between the head 222 and the flange 316 in order to electrically insulate the secondary battery charge and discharge pin 220 and the flange 316 during the charge and discharge of the secondary battery.

The insulating member 230 may have a shape corresponding to a shape of the head 222 while having a thin thickness to be disposed along an outer peripheral surface of the head 222 in order to effectively insulate the secondary battery charge and discharge pin 220 and the flange 316. For example, when the shape of the head 222 is a cylindrical shape including a through-hole in a center, the shape of the insulating member 230 may be a columnar shape with a curvature corresponding to an outer peripheral surface of the cylindrical shape or a part of the column.

A size of the head 222 of the secondary battery charge and discharge pin 220 may correspond to a size of the terminal 312 of the secondary battery. For example, when the shape of the head 222 of the secondary battery charge and discharge pin 220 is the cylindrical shape, a diameter of the head 222 may be 40% to 100% of a width of the terminal 312 of the secondary battery. In some embodiments, the width of the secondary battery terminal 312 may not exceed a depth of a secondary battery body case 314. In some embodiments, the diameter of the head 222 of the secondary battery charge and discharge pin 220 may be 5 mm to 6 mm.

A total width of the secondary battery charge and discharge pin 220 including the head 222 and the insulating member 230 may be less than or equal to the depth of the body case 314 of the secondary battery. For example, when the shape of the head 222 of the secondary battery charge and discharge pin 220 is the cylindrical shape, a diameter of the cylindrical shape including the head 222 and the insulating member 230 disposed along a part of the outer peripheral surface of the head 222 may be 40% to 90% of the depth of the body case 314 of the secondary battery. For example, when a width of the head 222 is 5 mm and the depth of the body case 314 of the secondary battery is 7 mm, a thickness of the insulating member 230 may be 0.1 mm to 1.3 mm.

In some embodiments, the insulating member 230 may be interposed without deformation between the flange 316 and a plane extending from an end of the terminal 312. Accordingly, the thickness of the insulating member 230 may be less than or equal to a distance between the flange 316 and one side surface of the end of the terminal 312 closest to the flange 316.

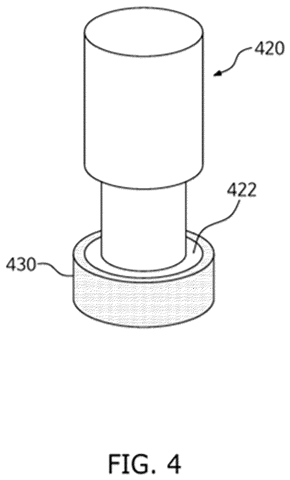

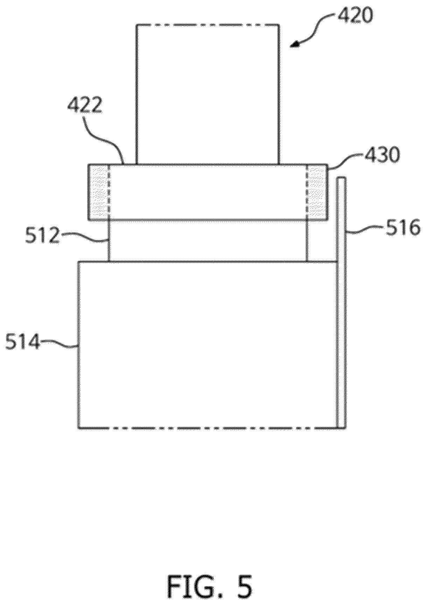

FIGS. 4 and 5 are diagrams illustrating a charge and discharge pin and a secondary battery case according to some embodiments of the present disclosure.

Referring to FIG. 4, a secondary battery charge and discharge pin 420 may include a head 422 that comes into contact with the terminal of the secondary battery and an insulating member 430 that covers the entire outer peripheral surface of the head 422.

Referring to FIG. 5, the insulating member 430 may be interposed between the head 422 and a flange 516 in order to electrically insulate the secondary battery charge and discharge pin 420 and the flange 516 during the charge and discharge of the secondary battery in a state where the head 422 comes into contact with a terminal 512 of the secondary battery.

For example, even though the secondary battery charge and discharge pin 420 comes into contact with the terminal 512 of the secondary battery in any rotational direction along a central axis of the secondary battery charge and discharge pin 420, the insulating member 430 may be formed on the entire outer peripheral surface of the head 422 to be disposed near the flange 516 formed in the secondary battery case. For example, when a shape of the head 422 is a cylindrical shape including a through-hole in a center, a shape of the insulating member 430 may be a columnar shape with a curvature corresponding to an outer peripheral surface of the cylindrical shape.

In some embodiments, a total width of the secondary battery charge and discharge pin 420 including the head 422 and the insulating member 430 may be less than or equal to a depth of a body case 514 of the secondary battery. For example, when the shape of the head 422 of the secondary battery charge and discharge pin 420 is the cylindrical shape, a diameter of the cylindrical shape including the head 422 and the insulating member 430 disposed along the entire outer peripheral surface of the head 422 may be 40% to 90% of a depth of the body case 514 of the secondary battery. For example, when a width of the head 422 is 5 mm and the depth of the body case 514 of the secondary battery is 7 mm, a thickness of the insulating member 430 may be 0.1 mm to 0.65 mm.

The description of other configurations and components may be the same as the descriptions made with reference to FIGS. 2 and 3, and thus may not be repeated here.

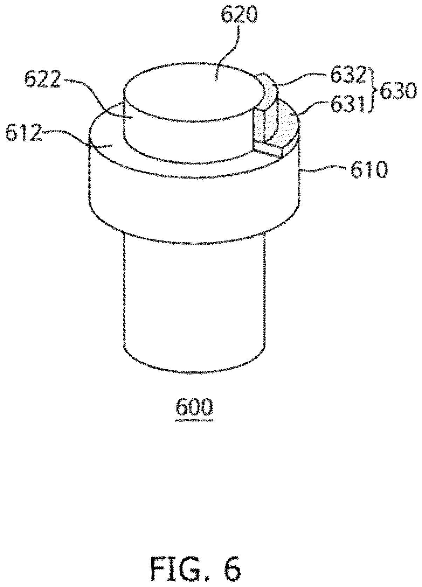

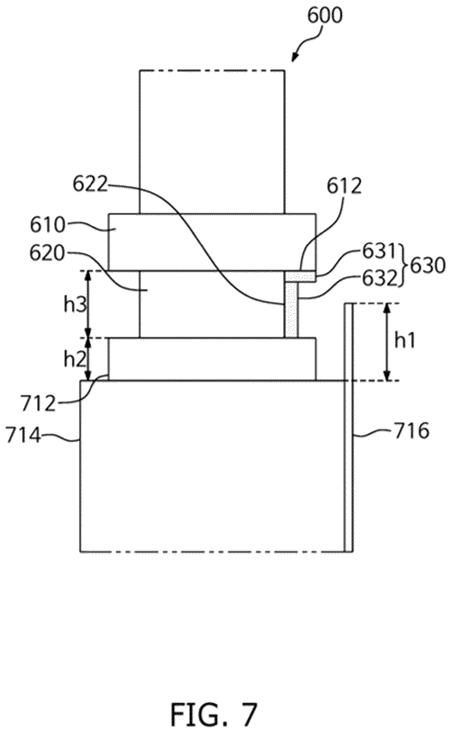

FIGS. 6 and 7 are diagrams illustrating a charge and discharge pin and a secondary battery case according to some embodiments of the present disclosure.

Referring to FIGS. 6 and 7, a head of a charge and discharge pin 600 may include a first head 610 and a second head 620. In some embodiments, the second head 620 may come into direct contact with a terminal 712 of the secondary battery. The first head 610 may be disposed at a bottom of the second head 620, and may be made of the same or substantially the same material as the second head 620, and may be electrically connected.

In some embodiments, a diameter of the first head 610 may be larger than a diameter of the second head 620. For example, the diameter of the first head 610 may be 5 mm to 6 mm, and the diameter of the second head 620 may be 3 mm to 5 mm.

As illustrated in FIG. 6, an insulating member 630 may be disposed on at least a part of an outer peripheral surface 622 of the second head 620 and at least a part of an upper surface 612 of the first head 610. For example, a second insulating member 632 may be disposed on at least a part of the outer peripheral surface 622 of the second head 620, and a first insulating member 631 may be disposed on at least a part of the upper surface 612 of the first head 610. For example, the first insulating member 631 and the second insulating member 632 may be made of the same or substantially the same material, may be connected to each other, and may be included in an integral insulating member 630.

As illustrated in FIG. 7, the insulating member 630 may be disposed near a flange 716 formed in the secondary battery case in a state where the second head 620 comes into contact with the terminal 712 of the secondary battery. For example, the insulating member 630 may be interposed between the first head 610 and the flange 716 and between the second head 620 and the flange 716 in order to electrically insulate the secondary battery charge and discharge pin 600 and the flange 716 during the charge and discharge of the secondary battery.

A size of the second head 620 may correspond to a size of the terminal 712 of the secondary battery. For example, when a shape of the second head 620 is a cylindrical shape, a diameter of the second head 620 may be 40% to 100% of a width of the terminal 712 of the secondary battery. In some embodiments, the width of the terminal 712 of the secondary battery may not exceed a depth of a body case 714 of the secondary battery.

A combined length of the width of the second head 620 and a thickness of the second insulating member 632 disposed on the outer peripheral surface 622 of the second head 620 may be less than or equal to the depth of the body case 714 of the secondary battery. For example, the combined length of the width of the second head 620 and the thickness of the second insulating member 632 disposed on the outer peripheral surface 622 of the second head 620 may be 40% to 90% of the depth of the body case 714 of the secondary battery.

However, a width or a diameter of the first head 610 is not limited to the above examples. In some embodiments, a size or a width of the first head 610 may be determined in accordance with the intensity of current used during a charge and discharge test of the secondary battery. For example, in order to use a current of 20 A, the first head 610 may have a cylindrical shape with a diameter of 5 mm to 6 mm.

In FIG. 6, although it has been illustrated that the shapes of the first head 610 and the second head 620 are the cylindrical shapes, the shapes thereof are not limited thereto. For example, the shape of the first head 610 and the second head 620 may be a rectangular column.

According to some embodiments, a height h3 of the second head 620 may be greater than or equal to a difference between a height h1 of the flange 716 formed in the case of the secondary battery and a height h2 of the terminal. In some examples, the sum of the height h3 of the second head 620 and the height h2 of the terminal may be greater than or equal to the sum of the height h1 of the flange 716 formed in the case of the secondary battery and the thickness of the first insulating member 631. With such a configuration, even when the width or the diameter of the first head 610 disposed on top of the second head 620 is greater than or equal to the depth of the body case 714 of the secondary battery, the first head 610 may not come into contact with the flange 716.

The description of other configurations and components may be the same as the descriptions made with reference to FIGS. 2 and 3, and thus may not be repeated here.

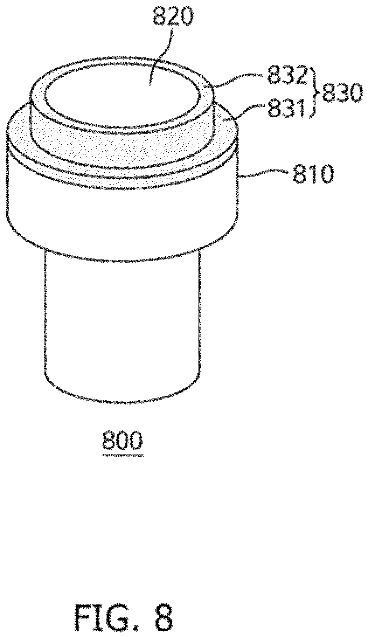

FIG. 8 is a diagram illustrating an a charge and discharge pin according to some embodiments of the present disclosure.

Referring to FIG. 8, in a charge and discharge pin 800 according to some embodiments, an insulating member 830 may be disposed on the entire outer peripheral surface of a second head 820 and the entire upper surface of a first head 810. In some embodiments, the insulating member 830 may include a first insulating member 831 and a second insulating member 832.

The second insulating member 832 may be disposed on the entire outer peripheral surface of the second head 820, and the first insulating member 831 may be disposed on the entire upper surface of the first head 810. For example, even though the secondary battery charge and discharge pin 800 comes into contact with the terminal of the secondary battery in any rotational direction along a central axis of the secondary battery charge and discharge pin 800, the insulating member 830 may be formed on the entire outer peripheral surface of the second head 820 and the entire upper surface of the first head 810 to be disposed near the flange formed in the secondary battery case.

The first insulating member 831 and the second insulating member 832 may be made of the same or substantially the same material, may be connected to each other, and may form the integral insulating member 830.

The description of other configurations and components may be the same as the descriptions made with reference to FIGS. 6 and 7, and thus may not be repeated here.

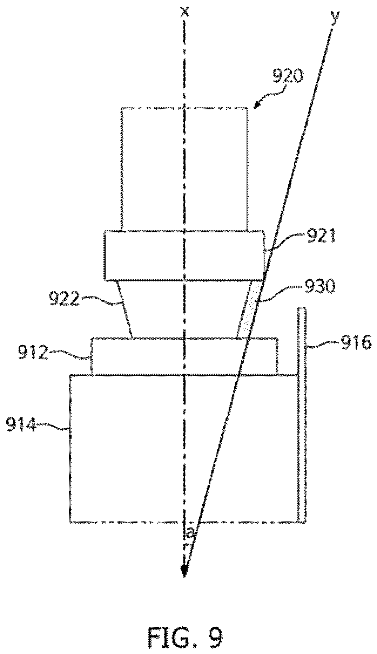

FIG. 9 is a diagram illustrating appearances of a charge and discharge pin and a secondary battery case according to some embodiments of the present disclosure.

Referring to FIG. 9, a charge and discharge pin 920 may include a first head 921 and a second head 922 that come into direct contact with a terminal 912 of the secondary battery. The first head 921 may be disposed at a bottom of the second head 922, may be made of the same or substantially the same material as the second head 922, and may be electrically connected. A diameter of a surface of the second head 922 that comes into direct contact with the terminal 912 of the secondary battery may be larger than a diameter of the first head 921.

According to some embodiments, the second head 922 may include an inclined surface inclined at a set or predetermined angle a with respect to an extending direction x of the first head 921 and the second head 922. For example, an angle a formed by a straight line y extending parallel to the inclined surface of the second head 922 with respect to the extending direction x of the first head 921 and the second head 922 may be an acute angle.

An insulating member 930 may be disposed on at least a part of the inclined surface of the second head 922. As illustrated in FIG. 9, the insulating member 930 may be disposed near a flange 916 formed in the secondary battery case in a state where the second head 922 comes into contact with the terminal 912 of the secondary battery. For example, the insulating member 930 may be interposed between the inclined surface of the second head 922 and the flange 916 in order to electrically insulate the secondary battery charge and discharge pin 920 and the flange 916 during the charge and discharge of the secondary battery.

A combined length of the diameter of the surface of the second head 922 that comes into direct contact with the terminal 912 of the secondary battery and a thickness of the insulating member 930 disposed on the inclined surface of the second head 922 may be less than or equal to a depth of a body case 914 of the secondary battery. For example, the combined length of the diameter of the surface of the second head 922 that comes into direct contact with the terminal 912 of the secondary battery and the thickness of the insulating member 930 disposed on the inclined surface of the second head 922 is 40% to 90% of the depth of the body case 914 of the secondary battery.

The description of other configurations and components may be the same as the descriptions made with reference to FIGS. 2 and 3, and thus may not be repeated here.

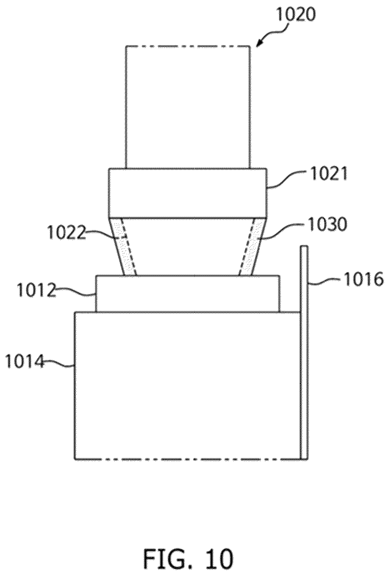

FIG. 10 is a diagram illustrating a charge and discharge pin and a secondary battery case according to some embodiments of the present disclosure.

Referring to FIG. 10, a secondary battery charge and discharge pin 1020 may include a first head 1021, a second head 1022 that comes into contact with a terminal 1012 of the secondary battery, and an insulating member 1030 that covers the entire inclined surface of the second head 1022.

For example, even though the secondary battery charge and discharge pin 1020 comes into contact with the terminal 1012 positioned on one side surface of a body case 1014 of the secondary battery case in any rotational direction along a central axis of the secondary battery charge and discharge pin 1020, the insulating member 1030 may be formed on the entire inclined surface of the second head 1022 to be disposed near a flange 1016 formed in the secondary battery case.

The description of other configurations and components may be the same as the descriptions made with reference to FIG. 9, and thus may not be repeated here.

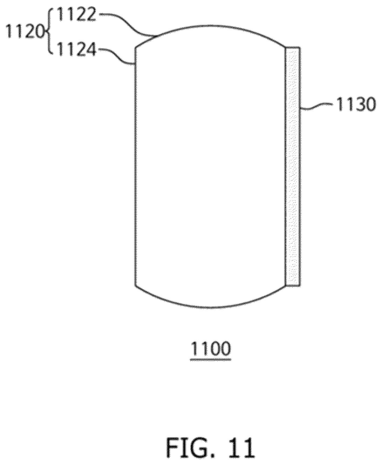

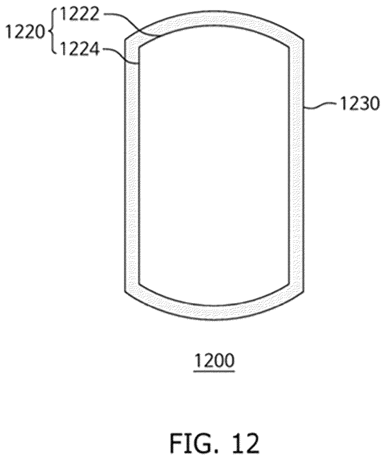

FIGS. 11 and 12 are diagrams illustrating a section of a charge and discharge pin head according to some embodiments of the present disclosure.

Referring to FIG. 11, a side surface 1120 of a charge and discharge pin head 1100 may include a curved surface portion 1122 and a flat surface portion 1124 connected to the curved surface portion 1122. An insulating member 1130 may be disposed on at least a part of the flat surface portion 1124. For example, the insulating member 1130 may be disposed near the flange formed in the secondary battery case in a state where the head 1100 comes into contact with the terminal of the secondary battery.

A width of the head 1100 in a narrow direction may correspond to a size of the terminal of the secondary battery. For example, the width of the head 1100 in the narrow direction may be 40% to 100% of the width of the terminal of the secondary battery. In some embodiments, the width of the secondary battery terminal may not exceed the depth of the secondary battery body case.

According to some embodiments, the head 1100 may include a plurality of flat surface portions 1124. For example, the head 1100 may have a radially symmetrical shape in consideration of (e.g., to accommodate for) rotation of a charge and discharge device. For example, the head 1100 may be molded or cast such that two flat surface portions 1124 face each other (e.g., are opposite from one another), as illustrated in FIG. 11. Because the plurality of flat surface portions 1124 are radially symmetric with each other, even though the charge and discharge pin head 1100 may rotate to come into contact with the terminal of the secondary battery in any rotational direction along a central axis of the secondary battery charge and discharge pin 1020, the insulating member 1130 may be disposed on the flat surface portion 1124 to be disposed near the flange formed in the secondary battery case. In FIG. 11, although it has been illustrated that the insulating member 1130 is disposed on only one flat surface portion 1124, the present disclosure is not limited thereto, and the insulating members 1130 may be disposed on both flat surface portions 1124.

As illustrated in FIG. 11, according to some embodiments, the head 1100 may include one flat surface portion 1124. For example, when the head 1100 comes into contact with the terminal of the secondary battery to perform the charge and discharge of the secondary battery, the flat surface portion 1124 may be disposed near the flange formed in the secondary battery case. The insulating member 1130 may be disposed on one flat surface portion 1124.

Referring to FIG. 12, a side surface 1220 of a charge and discharge pin head 1200 includes a curved surface portion 1222 and a flat surface portion 1224 connected to the curved surface portion 1222, and an insulating member 1230 may be disposed over the entire side surface 1220. In such embodiments, even though the secondary battery charge and discharge pin head 1200 comes into contact with the terminal of the secondary battery in any rotational direction along a central axis of the secondary battery charge and discharge pin head 1200, the insulating member 1230 may be disposed near the flange formed in the secondary battery case. The description of other configurations and components may be the same as the descriptions made with reference to FIG. 11, and thus may not be repeated here.

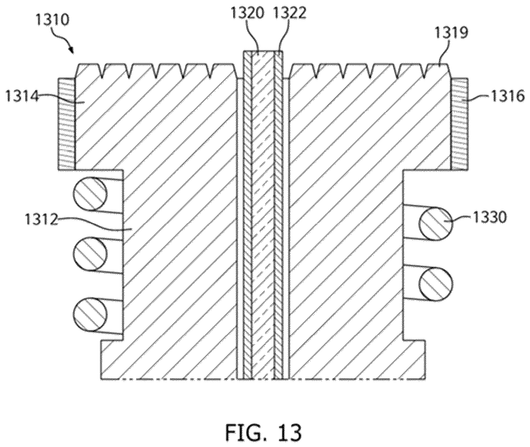

FIG. 13 is a longitudinal cross section of a probe for a secondary battery charge and discharge test according to some embodiments of the present disclosure.

The probe for a secondary battery charge and discharge test according to some embodiments may include an external plunger 1310 including a charge and discharge pin 1312 and an internal plunger 1320 that moves up and down inside the external plunger 1310. In some embodiments, the internal plunger 1320 may be electrically insulated from the external plunger 1310. The charge and discharge pin 1312 may include a head 1314 that comes into contact with the terminal of the secondary battery and an insulating member 1316 that covers at least a part of the head 1314. The description of the charge and discharge pin 1312 is the same as the description made with reference to FIGS. 1 to 12.

The probe for a secondary battery charge and discharge test according to some embodiments may further include an insulating layer 1322 disposed along an outer peripheral surface of the internal plunger 1320. In some embodiments, the insulating layer 1322 may provide electrical insulating properties between the external plunger 1310 and the internal plunger 1320 while suppressing wear and corrosion occurring in using the internal plunger 1320. In some embodiments, the insulating layer 1322 may be disposed on the entire front surface of the internal plunger 1320 except for the surface that comes into contact with the terminal of the secondary battery.

The insulating layer 1322 may be made of a polymer coating including Teflon (polytetrafluoroethylene (PTFE)), polypropylene (PP), polyethylene terephthalate (PET), polycarbonate (PC), or a combination thereof.

In some embodiments, the insulating layer 1322 may be made of a ceramic coating including alumina (Al₂O₃), zirconia (ZrO₂), parylene, epoxy resin, or a combination thereof. The insulating layer 1322 is not limited to the materials listed above, and may include various durable insulating materials as needed.

The probe for a secondary battery charge and discharge test may further include an elastic body 1330 disposed on an outer surface of the external plunger 1310. According to some embodiments, the elastic body 1330 may include a helical spring. The elastic body 1330 may distribute pressure applied to the probe and mitigate impact during the secondary battery charge and discharge test, and thus, the probe can be used for a long term.

A plurality of projections 1319 may be formed on a contact surface of the head 1314 that comes into direct contact with the terminal of the secondary battery. The plurality of projections 1319 may distribute pressure, may reduce wear of the contact surface between the terminal and the head 1314, and may maintain stable contact even during the long-term use of the probe for the charge and discharge test.

According to some embodiments of the present disclosure, it is possible to provide a probe for a charge and discharge test that can perform a charge and discharge test of a secondary battery by using high current by variously modifying a shape of a charge and discharge pin of a secondary battery while eliminating a risk of a short circuit.

Although the present disclosure has been described above with respect to embodiments thereof, the present disclosure is not limited thereto. Various modifications and variations can be made thereto by those skilled in the art within the scope of the present disclosure as defined by the appended claims.

### DESCRIPTION OF SOME OF THE REFERENCE SYMBOLS

- 110:: secondary battery case
- 112:: terminal
- 114:: body case
- 116:: cover case
- 118:: flange
- 120:: charge and discharge pin
- 122:: head
- 130:: insulating member

## Claims

1. A secondary battery charge and discharge pin (120, 220, 420, 600, 800, 1020, 1312) comprising:
a head (122, 222, 422, 1100, 1314) configured to come into contact with a terminal (112, 312, 512, 712, 912, 1012) of a secondary battery; and
an insulating member (130, 230, 430, 630, 830, 930, 1030, 1130, 1230, 1316) configured to cover at least a part of the head (122, 222, 422, 1100, 1314).

2. The secondary battery charge and discharge pin (120, 220, 420, 600, 800, 1020, 1312) according to claim 1,
wherein the insulating member (130, 230, 430, 630, 830, 930, 1030, 1130, 1230, 1316) is formed on the head (122, 222, 422, 1100, 1314) to be positioned near a flange (118, 316, 516, 716, 916, 1016) formed in a case (110) of the secondary battery in a state where the head (122, 222, 422, 1100, 1314) comes into contact with the terminal (112, 312, 512, 712, 912, 1012) of the secondary battery.

3. The secondary battery charge and discharge pin (220, 420, 600, 800, 1020, 1312) according to claim 1 or 2,
wherein the head (122, 222, 422, 1100, 1314) comprises a first head (610, 810, 921, 1021) and a second head (620, 820, 922, 1022).

4. The secondary battery charge and discharge pin (220, 420, 600, 800, 1020, 1312) according to claim 3,
wherein the second head (620, 820, 922, 1022) is configured to come into direct contact with the terminal (112, 312, 512, 712, 912, 1012) of the secondary battery.

5. The secondary battery charge and discharge pin (120, 220, 420, 600, 800, 1020, 1312) according to claim 3 or 4,
wherein a diameter of the first head (610, 810, 921, 1021) is larger than a diameter of the second head (620, 820, 922, 1022).

6. The secondary battery charge and discharge pin (220, 420, 600, 800, 1020, 1312) according to any one of claims 3 to 5,
wherein a height (h3) of the second head (620, 820, 922, 1022) is greater than or equal to a difference between a height (h1) of a flange (118, 316, 516, 716, 916, 1016) formed in a case (110) of the secondary battery and a height (h2) of the terminal (112, 312, 512, 712, 912, 1012).

7. The secondary battery charge and discharge pin (220, 420, 600, 800, 1020, 1312) according to any one of claims 3 to 6,
wherein the insulating member (130, 230, 430, 630, 830, 930, 1030, 1130, 1230, 1316) is on at least a part of an outer peripheral surface (622) of the second head (620, 820, 922, 1022) and at least a part of an upper surface (612) of the first head (610, 810, 921, 1021).

8. The secondary battery charge and discharge pin (220, 420, 600, 800, 1020, 1312) according to any one of claims 3 to 7,
wherein the second head (620, 820, 922, 1022) has an inclined surface inclined at an angle (a) with respect to an extending direction of the first head (610, 810, 921, 1021) and the second head (620, 820, 922, 1022).

9. The secondary battery charge and discharge pin (220, 420, 600, 800, 1020, 1312) according to claim 8,
wherein the insulating member (130, 230, 430, 630, 830, 930, 1030, 1130, 1230, 1316) is on at least a part of the inclined surface of the second head (620, 820, 922, 1022).

10. The secondary battery charge and discharge pin (120, 220, 420, 600, 800, 1020, 1312) according to any one of the preceding claims,
wherein a side surface (1120, 1220) of the head (122, 222, 422, 1100, 1314) comprises a curved surface portion (1122, 1222) and a flat surface portion (1124, 1224) connected to the curved surface portion (1122, 1222).

11. The secondary battery charge and discharge pin (120, 220, 420, 600, 800, 1020, 1312) according to claim 10,
wherein the insulating member (130, 230, 430, 630, 830, 930, 1030, 1130, 1230, 1316) is on at least a part of the flat surface portion (1124, 1224).

12. The secondary battery charge and discharge pin (120, 220, 420, 600, 800, 1020, 1312) according to any one of the preceding claims,
wherein a plurality of projections (1319) are formed on a contact surface of the head (122, 222, 422, 1100, 1314) that is configured to come into direct contact with the terminal (112, 312, 512, 712, 912, 1012) of the secondary battery.

13. A probe for a secondary battery charge and discharge test comprising:
an external plunger (1310) comprising a charge and discharge pin (1312) according to any one of the preceding claims; and
an internal plunger (1320) configured to move up and down inside the external plunger (1310),
wherein the internal plunger (1320) is electrically insulated from the external plunger (1310).

14. The probe for a secondary battery charge and discharge test according to claim 13, further comprising:
an insulating layer (1322) along an outer peripheral surface of the internal plunger (1320).

15. The probe for a secondary battery charge and discharge test according to claim 13 or 14, further comprising:
an elastic body (1330) on an outer surface of the external plunger (1310).
